# FASCICULE DE BREVET EUROPEEN

(11) **EP 3 536 826 B1**
(45) Date de publication et mention de la délivrance du brevet: **28.04.2021**
(21) Numéro de dépôt: 18161026.2
(22) Date de dépôt: 09.03.2018
(51) Int. Cl.: C25D 5/02, C25D 7/00, C25D 1/00, G04B 19/10, G04B 19/12, G04B 37/22, G04B 45/00, G03F 7/00, G03F 7/18

(54) **PROCEDE DE FABRICATION D'UN DECOR METALLIQUE SUR UN CADRAN ET CADRAN OBTENU SELON CE PROCEDE**
HERSTELLUNGSVERFAHREN EINES METALLDEKOREINSATZES AUF EINEM ZIFFERBLATT, UND MIT DIESEM VERFAHREN ERZEUGTES ZIFFERBLATT
METHOD FOR PRODUCING A METAL DECORATION ON A DIAL AND DIAL OBTAINED ACCORDING TO SAID METHOD

(43) Date de publication de la demande: 11.09.2019
(73) Titulaire: The Swatch Group Research and Development Ltd, 2074 Marin (CH)
(72) Inventeur: Laforge, Elias, 2000 Neuchâtel (CH); Haemmerli, Alexandre, 2000 Neuchâtel (CH); Tixier, Benjamin, 2000 Neuchâtel (CH); Grossenbacher, Pascal, 2000 Neuchâtel (CH); Vuille, Pierry, 2338 Les Emibois (CH)
(74) Mandataire: ICB SA

(56) Documents cités:
- EP-A1- 2 380 864
- CH-B1- 704 955
- JONGHO PARK ET AL: "Fabrication of metallic microstructure on curved substrate by optical soft lithography and copper electroplating", SENSORS AND ACTUATORS A: PHYSICAL, vol. 168, no. 1, 1 juillet 2011 (2011-07-01), pages 105-111, XP055502651, NL ISSN: 0924-4247, DOI: 10.1016/j.sna.2011.03.024
- REBECCA J. JACKMAN ET AL: "Three-Dimensional Metallic Microstructures Fabricated by Soft Lithography and Microelectrodeposition", LANGMUIR, vol. 15, no. 3, 1 février 1999 (1999-02-01), pages 826-836, XP055344707, US ISSN: 0743-7463, DOI: 10.1021/la980857y

## Description

### Domaine de l'invention

La présente invention concerne un procédé de fabrication d'un décor métallique par une technologie de type LIGA. En particulier l'invention concerne un tel procédé pour la fabrication d'un cadran en céramique bombé avec un décor métallique s'adaptant de façon optimale sur le cadran. L'invention concerne également un tel cadran obtenu par ce procédé.

### Arrière-plan de l'invention

La technologie LIGA (Lithographie Galvanik Abformung) développée par W. Ehrfeld du Karlsruhe Nuclear Research Center, Allemagne) dans les années 80 s'est révélée intéressante pour la fabrication de microstructures métalliques de haute précision.

Dans son principe, la technique LIGA consiste à déposer sur un substrat conducteur ou revêtu d'une couche conductrice, une couche d'une résine photosensible, à effectuer à travers un masque correspondant au contour de la microstructure désirée une irradiation X au moyen d'un synchrotron, à développer, c'est-à-dire à éliminer par des moyens physiques ou chimiques les portions de la couche de résine photosensible non irradiées afin de définir un moule ayant le contour de la microstructure, à déposer galvaniquement un métal, typiquement du nickel, dans le moule en résine photosensible, puis à éliminer le moule pour libérer la microstructure.

La qualité des microstructures obtenues ne prête pas à critique, mais la nécessité de mettre en œuvre un équipement coûteux (synchrotron) rend cette technique peu compatible avec une production de masse de microstructures devant avoir un faible coût unitaire.

C'est pourquoi sur la base de ce procédé LIGA ont été développés des procédé analogues mais utilisant des résines photosensibles aux UV. Un tel procédé est notamment décrit dans le document CH 704 955, et comprend les étapes suivantes :
- se munir d'un substrat dont au moins une des faces est conductrice ;
- appliquer sur la face conductrice du substrat une couche de résine photosensible ;
- irradier la couche de résine à travers un masque définissant le contour de la microstructure désirée ;
- dissoudre les zones non irradiées de la couche de résine photosensible pour faire apparaître par endroit la face conductrice du substrat ;
- déposer galvaniquement des couches alternativement d'un premier métal et d'au moins un deuxième métal à partir de ladite face conductrice pour former un bloc atteignant sensiblement la surface supérieure de la résine photosensible, ledit bloc étant formé d'un empilement de couches des premier et deuxième métaux ;
- séparer par délamination la couche de résine et le bloc électrodéposé du substrat ;
- éliminer la couche de résine photosensible de la structure délaminée pour libérer la microstructure ainsi formée.

La réalisation de décors métalliques par dépôt galvanique selon ce procédé de l'art antérieur est faite sur une surface plane et sa mise en œuvre sur une pièce présentant surface bombée est bien plus complexe, la courbure de la pièce ne permettant pas de monter correctement les décors.

On connait également du brevet EP 2 380 864 et de la publication Sensors and Actuators A: Physical, 168 (1), pp. 105-111, 2011-07-01, Elsevier BV, NL, un élément céramique incrusté d'au moins un décor métallique.

### Résumé de l'invention

La présente invention a pour but de remédier aux inconvénients susmentionnés ainsi qu'à d'autres encore en fournissant un procédé permettant de fabriquer des décors métalliques se conformant à la courbure des pièces à décorer.

La présente invention a également pour but de fournir un tel procédé qui soit simple et peu couteux à mettre en œuvre.

A cet effet l'invention a pour objet un procédé de fabrication d'au moins un décor métallique sur un substrat en matériau isolant présentant une surface bombée comprenant les étapes suivantes :
a) se munir d'un substrat non conducteur, par exemple en matière céramique, présentant une surface bombée, déposer au moins une première couche d'accroche, et une deuxième couche électriquement conductrice, via un procédé PVD ou équivalent;
b) déposer une troisième couche d'accroche via un procédé PVD ou équivalent ;
c) appliquer une couche de résine photosensible ;
d) irradier la couche de résine à travers un masque définissant la géométrie des décors désirés ;
e) dissoudre les zones non irradiées de la couche de résine photosensible pour faire apparaître la troisième couche d'accroche à l'emplacement des décors ;
f) éliminer la troisième couche d'accroche à l'emplacement des décors pour faire apparaitre la deuxième couche électriquement conductrice;
g) déposer galvaniquement une couche d'un métal à partir de ladite face conductrice pour former un bloc atteignant sensiblement la surface supérieure de la résine photosensible ;
h) éliminer la couche de résine restante par gravure plasma ;
i) éliminer les première, deuxième et troisième couches par une gravure humide.

Ce procédé permet donc la réalisation de pièces terminées en céramique présentant une surface bombée avec des décors métalliques en relief s'adaptant parfaitement à la surface.

Conformément à d'autres variantes avantageuses de l'invention :
- ladite première couche d'accroche est du type Ti, Ta, Cr ou Th ;
- ladite deuxième couche électriquement conductrice est du type Au, Pt, Ag, Cr, Pd, TiN, CrN, ZrN, Ni ;
- ladite troisième couche d'accroche est du type SiO2, TiO2, AIN ou SixNy;
- la première couche d'accroche présente une épaisseur comprise entre 30nm et 80nm ;
- la deuxième couche conductrice présente une épaisseur comprise entre 30nm et 80nm ;
- la troisième couche d'accroche présente une épaisseur d'au moins 10nm ;
- selon une variante du procédé, durant l'étape g), un premier métal est déposé à hauteur du moule, et avant l'étape i), le procédé comporte une étape h') de dépôt d'un deuxième métal recouvrant le premier métal déposé ;
- le substrat en matériau isolant, est un substrat non conducteur électriquement en céramique, en saphir, en nacre, en verre, en quartz, en diamant, en matière minérale (granit, marbre, ...), en polymères, en composites ou en émail.

Enfin, l'invention se rapporte à un cadran bombé en matériau isolant présentant des décors métalliques, destiné à être rapporté sur une boîte de montre, et obtenu selon un procédé conforme à l'invention, les décorations étant des index, des appliques, et/ou un logo.

On comprend donc que le procédé de l'invention trouve une application particulièrement avantageuse pour la fabrication de pièces décoratives pour les pièces d'horlogerie.

### Description sommaire des dessins

D'autres caractéristiques et avantages de la présente invention ressortiront plus clairement de la description détaillée qui suit d'un exemple de réalisation d'un procédé selon l'invention, cet exemple étant donné seulement à titre purement illustratif et non limitatif, en liaison avec le dessin annexé sur lequel :

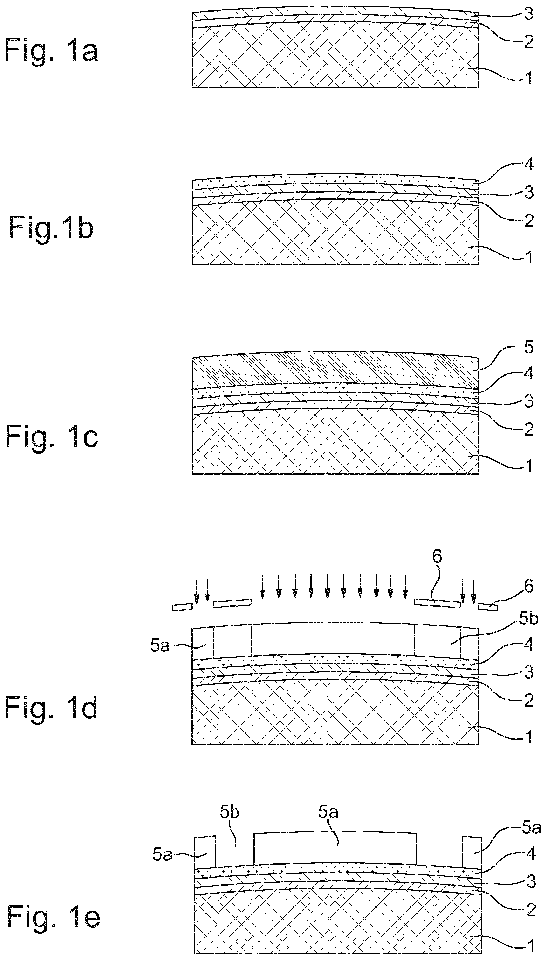

- les figures 1a à 1i illustrent les étapes de procédé d'un mode de réalisation de l'invention en vue de la réalisation d'un cadran muni d'appliques.

### Description détaillée des modes de réalisation préférés

Le substrat 1 utilisé dans l'étape a) du procédé selon l'invention est, par exemple, formé par un substrat en céramique, saphir, émail ou autre, et présentant une surface bombée. Lors de la première étape a) du procédé on dépose, par exemple, par procédé physique en phase vapeur (PVD), une première couche d'accroche 2 et une deuxième couche conductrice 3, c'est-à-dire une couche apte à démarrer un dépôt métallique par voie galvanique. Typiquement, la couche d'accroche 2 est du type Ti, Ta, Cr ou Th, et présente une épaisseur comprise entre 30nm et 80 nm, et la couche conductrice 3 est du type Au, Pt, Ag, Cr, Pd, TiN, CrN, ZrN, Ni (figure 1a) et présente également une épaisseur comprise entre 30nm et 80 nm. Les première et deuxième couches d'accroche peuvent être déposées par tout autre moyen connu de l'homme du métier.

Lors de l'étape b) une troisième couche d'accroche 4 est déposée, par exemple par dépôt physique en phase vapeur avec pulvérisation cathodique au magnétron, sur la deuxième couche conductrice 3. La couche d'accroche 4 est par exemple du type SiO₂, TiO₂, AIN ou SiₓN_{y} par exemple SiN ou Si₃N₄, et présente une épaisseur d'au moins 10nm.

Une telle couche d'accroche 4 a notamment pour avantage de permettre une adhérence optimale de la résine pour l'étape suivante du procédé. Cette troisième couche d'accroche 4 permet aussi de former une couche protectrice sur la deuxième couche conductrice en cas de décollement de la résine, ce qui évite une croissance galvanique non désirée lors des étapes ultérieures du procédé.

La résine photosensible 5 utilisée à l'étape c) du procédé selon l'invention est de préférence une résine de type négative à base d'époxy octofonctionnelle disponible chez Microchem sous la référence SU-8 et d'un photoinitiateur choisi parmi les sels de triarylsulfonium tels que ceux décrits dans le brevet US 4,058,401. Cette résine est susceptible d'être photopolymérisée sous l'action d'un rayonnement UV. On notera qu'un solvant qui s'est révélé approprié pour cette résine est le gammabutyrolactone (GBL).

Alternativement, une résine à base de phénolformaldéhyde de type Novolac en présence d'un photoinitiateur DNQ (DiazoNaphtoQuinone) peut également être utilisée.

La résine 5 est déposée sur le substrat 1 par tout moyen approprié, par enduction centrifuge, à la tournette, ou encore par sprayage jusqu'à l'épaisseur souhaitée. Typiquement l'épaisseur de résine est comprise entre 1 µm et 500 µm, et plus préférentiellement entre 20 µm et 300 µm. Selon l'épaisseur désirée et la technique de dépôt utilisée la résine 5 sera déposée en une ou plusieurs fois.

La résine 5 est ensuite chauffée entre 80 et 95° C pendant une durée dépendant de l'épaisseur déposée pour évacuer le solvant. Ce chauffage sèche et durcit la résine.

L'étape d) suivante illustrée à la figure 1d consiste à irradier la couche de résine 5 au moyen d'un rayonnement UV à travers un masque 6 définissant le contour des décors souhaités et ainsi des zones photopolymérisées 5a et des zones non photopolymérisées 5b. Typiquement, cette irradiation UV est de 200 à 1'000 mJ.cm-2, mesurée à une longueur d'onde typique de 365 nm dépend de l'épaisseur de la couche et du type de résine sélectionnée.

Le cas échéant, une étape de recuit de la couche de résine 5 peut être nécessaire pour compléter la photopolymérisation induite par l'irradiation UV. Cette étape de recuit est effectuée de préférence entre 90°C et 95°C pendant 15 à 30 mn. Les zones photopolymérisées 5a deviennent insensibles à une grande majorité de solvants. Par contre, les zones non photopolymérisées pourront ultérieurement être dissoutes par un solvant.

L'étape e) suivante illustrée à la figure 1e consiste à développer les zones non photopolymérisées 5b de la couche de résine photosensible pour faire apparaître par endroit la couche d'accroche 4 du substrat 1. Cette opération est réalisée par dissolution des zones non photopolymérisées 5b au moyen d'un solvant adéquat, par exemple choisi parmi le GBL (gammabutyrolactone) et le PGMEA (propylène glycol méthyle éthyle acétate). Un moule en résine photosensible photopolymérisées 5a présentant les contours d'un décor est ainsi réalisé.

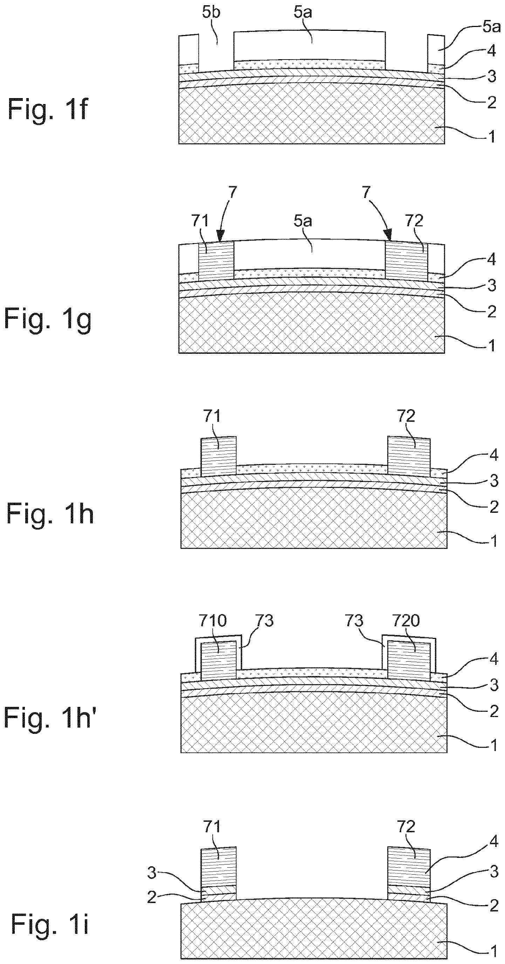

L'étape f) suivante illustrée à la figure 1f consiste à éliminer la troisième couche d'accroche 4 dans le moule formé pour faire apparaitre la deuxième couche conductrice 3. Typiquement, la troisième couche d'accroche 4 est éliminée au moyen d'une gravure plasma ou d'une gravure ionique réactive (RIE).

L'étape g) suivante illustrée à la figure 1g consiste à déposer galvaniquement dans les moules une couche d'un métal à partir de ladite couche conductrice 3 jusqu'à former une pluralité de blocs 71, 72, atteignant préférentiellement la hauteur des moules, l'épaisseur de la couche de métal étant comprise entre 1 µm et 500 µm, et plus préférentiellement entre 20 µm et 300 µm. Par métal dans ce contexte sont bien entendu compris les alliages métalliques. Typiquement, le métal sera choisi parmi l'ensemble comprenant le nickel, le cuivre, l'or ou l'argent, et, comme alliage, l'or-cuivre, le nickel-cobalt, le nickel-fer, le nickel-phosphore ou le nickel-tungstène.

Les conditions d'électroformage, notamment la composition des bains, la géométrie du système, les tensions et densités de courant, sont choisis pour chaque métal ou alliage à électrodéposer selon les techniques bien connues dans l'art de l'électroformage (cf. par exemple Di Bari G.A. "electroforming" Electroplating Engineering Handbook 4th Edition rédigée par L.J. Durney, publié par Van Nostrand Reinhold Compagny Inc., N.Y. USA 1984).

L'étape h) suivante illustrée à la figure 1h consiste à éliminer la couche de résine 5a des blocs électrodéposés 71, 72 et du substrat 1 au moyen d'une gravure plasma, ce qui permet d'enlever la résine sans endommager les blocs électrodéposés 71, 72.

A l'issue de cette étape h), on obtient un substrat 1 avec des blocs électrodéposés 71, 72 formant un décor sur le substrat 1, les première, deuxième et troisième couches 2, 3, 4 étant encore présentes par endroit, sur le substrat après l'élimination de la résine restante.

A l'étape i) illustrée à la figure 1i, les première, deuxième et troisième couches 2, 3, 4 sont éliminées au moyen d'au moins une gravure humide. Par exemple, les couches SiO₂ ou TiO₂ sont gravées avec de l'acide fluorhydrique ou BOE (buffered oxide etchant). La couche Au est gravée avec de l'eau régale (acide nitrique + acide chlorhydrique) ou du KI (iodure de potassium) ou KCN (cyanure de potassium). Le nickel est gravé avec de l'acide nitrique.

A l'issue de cette étape, les pièces obtenues peuvent être nettoyées, et éventuellement reprises sur une machine-outil pour opérer des usinages ou une terminaison esthétique. A ce stade, les pièces peuvent être directement utilisées ou bien soumises à divers traitements décoratifs et/ou fonctionnels, typiquement des dépôts physiques ou chimiques.

Selon une alternative de l'invention, à l'étape g) on dépose galvaniquement une couche d'un premier métal tel que par exemple du nickel à partir de ladite couche conductrice pour former un bloc 710, 720 d'une hauteur inférieure ou égale à la hauteur de la résine. L'étape suivante h) reste la même, et une étape additionnelle h') est effectuée au cours de laquelle on dépose galvaniquement une couche 73 d'un autre métal ou alliage, par exemple précieux tel que de l'or par-dessus la couche du premier métal. Enfin, à l'étape i) la couche d'accroche 4 et les couches conductrice 3 et d'accroche 2 sont éliminées par au moins une gravure humide.

Une telle alternative est moins couteuse et plus facile à mettre en œuvre, la croissance du nickel étant plus facile à maitriser et moins couteuse qu'un métal précieux tel que l'or.

Le procédé de l'invention trouve une application particulièrement avantageuse pour la fabrication de pièces décoratives pour pièces d'horlogerie, et plus particulièrement pour des cadrans bombés en matière non conductrice, présentant des décorations métalliques à sa surface. Les décorations peuvent être des index, des appliques, des logos ou des noms de marque par exemple. Grâce à ce procédé, on peut munir un cadran bombé en matière non conductrice de tout type de décoration métallique s'adaptant parfaitement à la courbure de la surface du cadran bombé, avec un positionnement très précis, et en procédé multi-pièces donc économiquement intéressant.

## Revendications

1. Procédé de fabrication d'au moins un décor métallique sur un substrat (1) en matériau isolant présentant une surface bombée comprenant les étapes suivantes :
a) se munir du substrat (1) et y déposer une première couche (2) d'accroche et une deuxième couche (3) électriquement conductrice via un dépôt en phase vapeur ;
b) déposer une troisième couche (4) d'accroche,
c) appliquer une couche (5) de résine photosensible ;
d) irradier la couche (5) de résine à travers un masque (6) définissant le contour des décors désirés ;
e) dissoudre les zones (5b) non irradiées de la couche de résine photosensible (5) pour faire apparaître par endroit la troisième couche d'accroche (4) à l'emplacement des décors ;
f) éliminer la troisième couche d'accroche (4) à l'emplacement des décors pour faire apparaitre la deuxième couche conductrice (3) ;
g) déposer galvaniquement une couche d'un métal (7) ou d'un alliage métallique à partir de ladite face conductrice pour former au moins un bloc (71, 72) atteignant sensiblement la surface supérieure de la résine photosensible (5) ;
h) éliminer la couche de résine (5) restante par gravure plasma ;
i) éliminer les première, deuxième et troisième couches par au moins une gravure humide.

2. Procédé selon la revendication 1, **caractérisé en ce que** ladite première couche d'accroche est du type Ti, Ta, Cr ou Th.

3. Procédé selon la revendication 1 ou 2, **caractérisé en ce que** ladite deuxième couche électriquement conductrice est du type Au, Pt, Ag, Cr, Pd, TiN, CrN, ZrN, Ni.

4. Procédé selon l'une quelconques des revendications 1 à 3, **caractérisé en ce que** ladite troisième couche d'accroche est du type SiO₂, TiO₂, AIN ou SiₓN_{y} TiO₂,

5. Procédé selon l'une des revendications précédentes, **caractérisé en ce que** la première couche d'accroche (2) présente une épaisseur comprise entre 30nm et 80nm.

6. Procédé selon l'une des revendications précédentes, **caractérisé en ce que** la deuxième couche conductrice (3) présente une épaisseur comprise entre 30nm et 80nm.

7. Procédé selon l'une des revendications précédentes, **caractérisé en ce que** la troisième couche d'accroche (4) présente une épaisseur d'au moins 10nm.

8. Procédé selon l'une des revendications précédentes, **caractérisé en ce que** :
- durant l'étape g), un premier métal est déposé à hauteur du moule ;
- avant l'étape i), le procédé comporte une étape h') de dépôt d'un deuxième métal ou alliage métallique recouvrant le premier métal déposé.

9. Procédé selon l'une des revendications précédentes, **caractérisé en ce que** le substrat (1) en matériau isolant, est un substrat en céramique, en saphir, en nacre, en verre, en quartz, en diamant, en matière minérale , en polymères, en composites, en verre ou en émail.

## Patentansprüche

1. Verfahren zur Herstellung mindestens einer Metallverzierung auf einem Substrat (1) aus isolierendem Werkstoff, das eine gewölbte Oberfläche aufweist, umfassend folgende Schritte:
a) Bereitstellen eines Substrats (1) und dortiges Abscheiden einer ersten Grundierungsschicht (2) und einer zweiten elektrisch leitfähigen Schicht (3) durch eine Gasphasenabscheidung;
b) Abscheiden einer dritten Grundierungsschicht (4),
c) Aufbringen einer Schicht (5) aus lichtempfindlichem Harz;
d) Bestrahlen der Harzschicht (5) durch eine Maske (6), welche die Kontur der gewünschten Verzierungen definiert;
e) Auflösen der nicht bestrahlten Zonen (5b) der Schicht aus lichtempfindlichem Harz (5), um die dritte Grundierungsschicht (4) an der Stelle der Verzierungen stellenweise sichtbar zu machen;
f) Entfernen der dritten Grundierungsschicht (4) an der Stelle der Verzierungen, um die zweite leitfähige Schicht (3) sichtbar zu machen;
g) galvanisches Abscheiden einer Schicht aus einem Metall (7) oder aus einer Metalllegierung ausgehend von der leitfähigen Fläche, um mindestens einen Block (71, 72) zu bilden, der im Wesentlichen die obere Oberfläche des lichtempfindlichen Harzes (5) erreicht;
h) Entfernen der verbleibenden Harzschicht (5) durch Plasmaätzen;
i) Entfernen der ersten, zweiten und dritten Schicht durch mindestens eine Nassätzung.

2. Verfahren nach Anspruch 1, **dadurch gekennzeichnet, dass** die erste Grundierungsschicht vom Typ Ti, Ta, Cr oder Th ist.

3. Verfahren nach Anspruch 1 oder 2, **dadurch gekennzeichnet, dass** die zweite elektrisch leitfähige Schicht vom Typ Au, Pt, Ag, Cr, Pd, TiN, CrN, ZrN, Ni ist.

4. Verfahren nach einem der Ansprüche 1 bis 3, **dadurch gekennzeichnet, dass** die dritte Grundierungsschicht vom Typ SiO₂, TiO₂, AIN oder SiₓN_{y} ist.

5. Verfahren nach einem der vorstehenden Ansprüche, **dadurch gekennzeichnet, dass** die erste Grundierungsschicht (2) eine Dicke aufweist, die zwischen 30 nm und 80 nm beträgt.

6. Verfahren nach einem der vorstehenden Ansprüche, **dadurch gekennzeichnet, dass** die zweite leitfähige Schicht (3) eine Dicke aufweist, die zwischen 30 nm und 80 nm beträgt.

7. Verfahren nach einem der vorstehenden Ansprüche, **dadurch gekennzeichnet, dass** die dritte Grundierungsschicht (4) eine Dicke von mindestens 10 nm aufweist.

8. Verfahren nach einem der vorstehenden Ansprüche, **dadurch gekennzeichnet, dass**:
- während des Schritts g) ein erstes Metall auf Höhe der Gießform abgeschieden wird;
- vor dem Schritt i) das Verfahren einen Schritt h') des Abscheidens eines zweiten Metalls oder einer Metalllegierung umfasst, womit das abgeschiedene erste Metall bedeckt wird.

9. Verfahren nach einem der vorstehenden Ansprüche, **dadurch gekennzeichnet, dass** das Substrat (1) aus isolierendem Werkstoff ein Substrat aus Keramik, aus Saphir, aus Perlmutter, aus Glas, aus Quarz, aus Diamant, aus mineralischem Material, aus Polymeren, aus Verbundstoffen, aus Glas oder aus Email ist.

## Claims

1. Method for fabricating at least one metal decoration on a substrate (1) made of insulating material having a domed surface including the following steps:
a) providing the substrate (1) and depositing therein a first adhesion layer (2) and a second electrically conductive layer (3) by vapour phase deposition;
b) depositing a third adhesion layer (4),
c) applying a photosensitive resin layer (5);
d) irradiating the resin layer (5) through a mask (6) defining the contour of the desired decorations;
e) dissolving the non-irradiated areas (5b) of the photosensitive resin layer (5) to reveal, in places, the third adhesion layer (4) where the decorations are located;
f) removing the third adhesion layer (4) where the decorations (4) are located to reveal the second conductive layer (3);
g) electrodepositing a layer of metal or metal alloy (7), starting from said conductive surface, to form at least one unit (71, 72) that substantially reaches the upper surface of the photosensitive resin (5);
h) removing the remaining resin layer (5) by plasma etching;
i) removing the first, second and third layers by at least one wet etch.

2. Method according to claim 1, **characterized in that** said first adhesion layer is of the Ti, Ta, Cr or Th type.

3. Method according to claim 1 or 2, **characterized in that** said second electrically conductive layer is of the Au, Pt, Ag, Cr, Pd, TiN, CrN, ZrN, Ni type.

4. Method according to any of claims 1 to 3, **characterized in that** said third adhesion layer is of the SiO₂, TiO₂, AIN or SiₓN_{y} type.

5. Method according to any of the preceding claims, **characterized in that** the first adhesion layer (2) has a thickness comprised between 30 nm and 80 nm.

6. Method according to any of the preceding claims, **characterized in that** the second conductive layer (3) has a thickness comprised between 30 nm and 80 nm.

7. Method according to any of the preceding claims, **characterized in that** the third adhesion layer (4) has a thickness of at least 10 nm.

8. Method according to any of the preceding claims, **characterized in that**:
- during step g), a first metal is deposited up to the top of the mould;
- before step i), the method includes a step h') of depositing a second metal or metal alloy covering the first deposited metal.

9. Method according to any of the preceding claims, **characterized in that** the substrate (1) made of insulating material is a substrate made from ceramic, sapphire, mother of pearl, glass, quartz, diamond, mineral material, polymers, composites, glass or enamel.
